Europäisches Patentamt

**European Patent Office**

**Office européen des brevets**

(11) Publication number: **0 262 264**

**A1**

(12) **EUROPEAN PATENT APPLICATION**

(21) Application number: **86306692.4**

(22) Date of filing: **29.08.86**

(51) Int. Cl.³: **G 01 R 5/26**
**G 01 R 19/03**

(43) Date of publication of application:
**06.04.88 Bulletin 88/14**

(84) Designated Contracting States:
**BE CH DE FR GB IT LI NL SE**

(71) Applicant: **Nippon Seiki Co. Ltd.**
**2-2-34, Higashi Zaoh**
**Nagaoka-city Niigata-pref(JP)**

(72) Inventor: **Nishiwaki, Shigeo**
**1-8-8 Miyasakae**
**Nagaoka Niigata(JP)**

(74) Representative: **Votier, Sidney David et al,**
**CARPMAELS & RANSFORD 43, Bloomsbury Square**
**London WC1A 2RA(GB)**

(54) **Indicating instrument.**

(57) An indicating instrument of the present invention comprises a pointer shaft (25) borne by bearing members (23, 24) within an instrument frame (21), a pointer (26) fixedly attached to the pointer shaft (25), and a deforming characteristic member (27) making deforming operation in accordance with temperature variation due to heat produced by electric current passed through resistance and formed in a spiral shape, the inner end of the spiral deforming characteristic member being fixed to the pointer shaft (25) and the outer end thereof being fixed to the instrument frame (21), wherein it is adapted such that the deforming characteristic member (27) is caused to make deforming operation in accordance with strength of passed current and said pointer shaft (25) is rotated in conjunction with this operation. By such arrangement, the angle of the operating range of the pointer (26) can be widened, hence spacing between graduations of the scale on the dial face can be widened, and thereby, readability of the scale by comparison of the pointer with the indicating portion on the dial face can be improved.

## TITLE OF THE INVENTION

### INDICATING INSTRUMENT

### BACKGROUND OF THE INVENTION

1. FIELD OF THE INVENTION:

The present invention relates to an indicating instrument and more particularly to an indicating instrument operating in a manner to follow temperature variation caused by heat produced by electric current passed through resistance.

2. Description of the Prior Art:

Indicating instruments operating in a manner to follow temperature variation caused by heat produced by electric current passed through resistance of this type in general are known, for example, by specifications of U.S. Patent No. 2,991,418 and No. 4,188,827.

Describing such a general indicating instrument with reference to Fig. 8, a portion of an instrument frame 1 is bent so that a support portion 2 may be formed, a pointer shaft 3 is welded to the top end of the support member 2, a pointer 4 is pivotally

1

attached to the pointer shaft 3 for rotation, and a slot 5 is made in the rear of the pointer 4.

And, there is provided a bimetallic element 9 having an indicating portion 7 and a temperature compensating portion 8 and shaped in a U form, wherein the indicating portion 7 is coiled by a heating wire 6 converting variation in the strength of the current flowing therethrough to heat, the current varying in accordance with changes in a detecting portion of such as a water temperature gage, for example, of a motor vehicle. While the temperature compensating portion 8 is fixed at its end to an adjustment plate 10, the indicating portion 7 coiled by the heating coil 6 is provided with a pin 11 welded to its end, and this pin 11 is slidably engaged with the slot 5 made in the above mentioned pointer 4, whereby the pointer 4 is rotated around the pointer shaft 3 to make its indication in conjunction with the indicating portion 7 of the U-formed bimetallic element 9 to be bent by the heat developed in the heating wire 6.

Around the end of the pointer 4, there is disposed a dial face 13 with a scale 12 printed thereon, which corresponds to the range of movement of the pointer 4. The adjustment plate 10 is operably coupled with the instrument frame 1 at the top thereof for adjusting movement so that the values of indication may be adjusted by the movement of the adjustment plate 10.

In such arrangement, variation in the strength of the current flowing through the heating wire 6 in accordance with variation in resistance in the detecting portion of such as a water temperature gage is converted to heat in the heating wire 6, which causes the U-formed bimetallic element 9 to make deformation and this is utilized to cause the pointer 4 to make its indication. More particularly, it is performed by displacement due to bending of the indicating portion 7 of the U-formed bimetallic element 9.

However, since the indicating portion 7 is adapted to be bent in accordance with temperature variation due to resistance heat produced by the current flowing through the above mentioned heating wire 6, and thereby, the pin 11 provided at the end of the indicating portion 7 is slid along the slot 5 made in the pointer 4 and the pointer 4 is rotated so as to make its indication, the rotation of the pointer 4 is generally confined within a narrow angle. Therefore, it follows that the spacing between the graduations of the scale 12 on the dial face 13 as well as the range of measurement is not large enough for making precise
reading of the scale by comparison of the pointer 4 with
the scale 12 on the dial face 13.  And thus, there was a
problem that the readability provided by the prior art
was not satisfactory.

## SUMMARY OF THE INVENTION

The present invention has been made to
overcome the above mentioned problem and it is a primary
object of the present invention to provide an indicating
instrument which is simple in structure and capable of
indicating a wide range of indicated values.

## BRIEF DESCRIPTION OF THE DRAWINGS

Fig. 1 is a sectional view of principal
portion showing a first embodiment of the present
invention;

Fig. 2 is a sectional view of principal
portion showing a second embodiment of the invention;

Fig. 3 is a sectional view showing a third
embodiment of the invention;

Fig. 4 is a perspective view showing principal
portion of Fig. 3;

Fig. 5 is a sectional view showing a fourth

4

embodiment of the invention;

Fig. 6 is a perspective view showing principal portion of Fig. 5;

Fig. 7 is a perspective view of principal portion showing a practical example of the invention; and

Fig. 8 is a perspective view showing an indicating instrument of the prior art.

<u>DETAILED DESCRIPTION</u>

<u>OF</u>

<u>THE PREFERRED EMBODIMENTS</u>

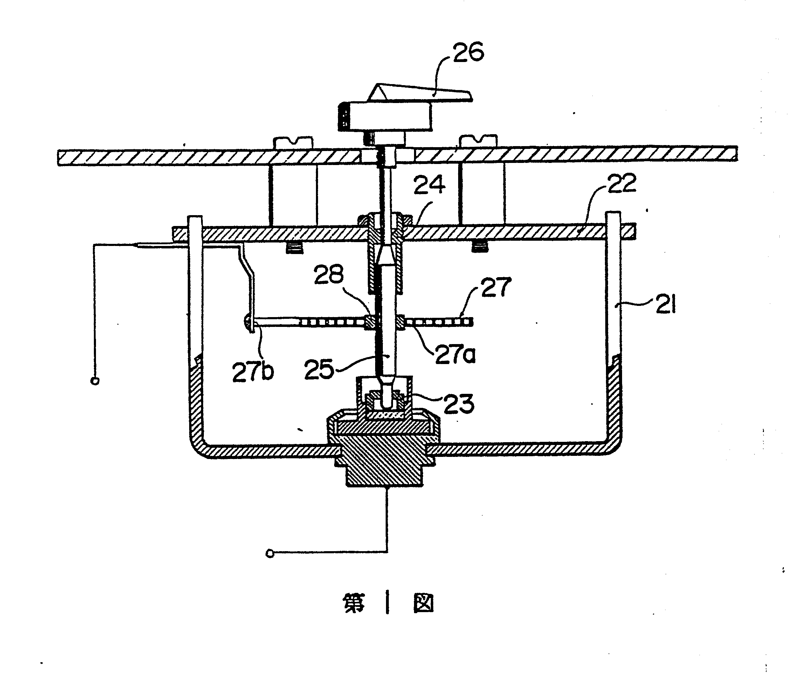

Fig. 1 shows a first embodiment of the present invention, in which the body frame of the instrument is formed of an instrument frame 21 with a plate 22 mounted on the opening end thereof. A lower bearing member 23 is disposed on the instrument frame 21 and an upper bearing member 24 is disposed in the plate 22, and by both the bearing members 23 and 24 is borne a pointer shaft 25, and a pointer 26 is fixedly attached to the upper end of the pointer shaft 25.

Within the body frame, there is provided a deforming characteristic member 27 made, for example, of a bimetallic material, shaped in a spiral form, and adapted to make deforming operation according to temperature variation due to heat produced by electric current passed through resistance. The inner end 27a of the spiral deforming characteristic member 27 is fixed to the pointer shaft 25 through a support member 28 and the outer end 27b is fixed to the instrument frame 21.

The outer end 27b of the deforming characteristic member 27 is connected to a positive electrode of a detection portion of such as a water temperature gage, for example, for a vehicle such as a motorcar and the inner end 27a of the deforming characteristic member 27 is connected to the negative electrode of the detection portion, whereby electric current is arranged to be directly passed through the deforming characteristic member 27.

Thus, it is adapted such that, in accordance with changes in the detection portion of such as a water temperature gage of a motor vehicle, electric current is directly passed through the deforming characteristic member 27, and according to the strength of the passed current, the deforming characteristic member 27 makes deforming operation caused by the heat produced in its own resistance, and in conjunction with this deforming operation of the deforming characteristic member 27, the

6

pointer shaft 25 is rotated. In this way, the deforming operation of the deforming characteristic member 27 is transmitted to the pointer shaft 25 for rotation thereby to cause the pointer 26 to make its indication.

At this time, the heat W produced in the deforming characteristic member 27 is determined by the resistance value R along the length of the deforming characteristic member 27 and the current value I passed therethrough. That is, the heat W is in the relationship, $W \propto RI^2$, with the current I, and the pointer 26 is rotated through the angle corresponding to the heat W to make its indication.

Since it is adapted such that the pointer shaft 25 is rotated by the deforming characteristic member 27 making deforming operation according to temperature variation due to resistance heat by the current passing therethrough, the parts used can be reduced in number, and further, since the structure can be made simpler, efficiency in assembly work can be improved by virtue of avoided interference with the mechanism of the indicating instrument within the body frame of the instrument and its installation space can be greatly reduced.

And, by shaping the deforming characteristic

7

member 27 in a spiral form and arranging so that the deforming operation of the deforming characteristic member 27 is transmitted to the pointer shaft 25 to rotate the same, it is enabled to enlarge the range of indication of the pointer 26, and hence, the spacing between the graduations of the scale on the dial face can be widened and the readability of the scale by comparison of the pointer 26 with the dial can be improved.

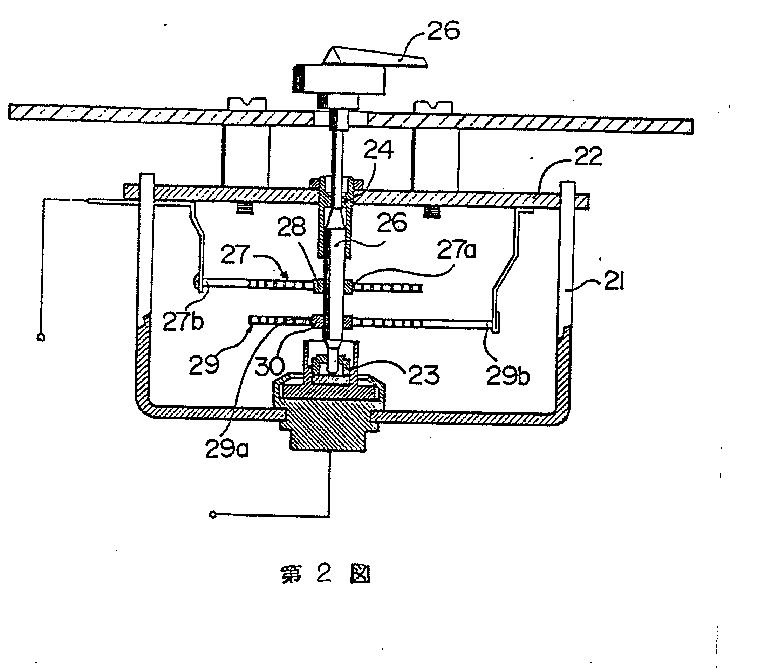

Fig. 2 shows a second embodiment of the present invention, in which the body frame of the instrument is formed of an instrument frame 21 with a plate 22 mounted on the opening end thereof. A lower bearing member 23 is disposed on the instrument frame 21 and an upper bearing member 24 is disposed in the plate 22, and by both the bearing members 23 and 24 is borne a pointer shaft 25, and a pointer 26 is fixedly attached to the upper end of the pointer shaft 25.

Within the body frame, there is provided a first deforming characteristic member 27 made, for example, of a bimetallic material, shaped in a spiral form, and adapted to make deforming operation according to temperature variation due to heat produced by electric current passed through resistance. The inner

8

end 27a of the first deforming characteristic member 27 is fixedly pressed into the pointer shaft 25 through a support member 28 and the outer end 27b is fixed to the instrument frame 21.

The outer end 27b of the first deforming characteristic member 27 is connected to a positive electrode of a detection portion of a level gage, for example, for a motor vehicle and the inner end thereof is connected to the negative electrode of the detection portion, whereby electric current is arranged to be directly passed through the first deforming characteristic member 27.

There is also provided a second deforming characteristic member 29 which is made of a bimetallic material or the like, shaped in a spiral form, and adapted to make deforming operation according to temperature variation similarly to the first deforming characteristic member 27, but its spiral direction is made to be opposite to the first deforming characteristic member 27. The inner end 29a of the same is fixedly pressed into the pointer shaft 25 through a support member 30 and the outer end 29b is fixed to the instrument frame 21.

In the present case, as the first deforming

9

characteristic member 27 and the second deforming characteristic member 29 are used such that will provide virtually equal characteristics as to the deforming characteristic to make deforming operation according to temperature variation.

Thus, it is adapted such that, in accordance with changes in the detection portion of the indicating instrument, electric current is directly passed through the first deforming characteristic member 27, and according to the strength of the passed current, the first deforming characteristic member 27 makes deforming operation caused by the heat produced in its own resistance, and in conjunction with this deforming operation of the first deforming characteristic member 27, the pointer shaft 25 is rotated. In this way, the deforming operation of the first deforming characteristic member 27 is transmitted to the pointer shaft 25 for rotation thereby to cause the pointer 26 to make its indication.

And, in the case where there is present a difference in ambient temperature between inside and outside the instrument, since the deforming characteristics of the first deforming characteristic member 27 and the second deforming characteristic member

10

29 to make deforming operation according to temperature variation are arranged to be virtually equal but the directions of the spirals of these members are arranged to be opposite to each other, when the amount of movement of the first deforming characteristic member 27 according to the temperature difference is represented by $T_1$, the amount of movement of the second deforming characteristic member 29 according to the temperature difference is produced in the opposite direction to the amount of movement $T_1$ of the first deforming characteristic member 27, hence it will be represented by $-T_1$, and thus, the amount of relative movement, $T$, at the time when the temperature difference is present will become $T = T_1 + (-T_1) = 0$, which means that the operating torque acting on the pointer shaft 25 due to the temperature difference is nullified by the amounts of movement of both the first and second deforming characteristic members 27 and 29 canceling each other and the change in the amount of indication is virtually absorbed thereby, and thus, a balanced state is secured.

In the present case, the heat W produced in the first deforming characteristic member 27 is determined by the resistance value R of the first deforming characteristic member 27 along its length and

11

the current value I passed therethrough, i.e., $W \propto RI^2$, and therefore, the pointer 26 is caused to rotate through the angle corresponding to the heat W to make its indication.

As described in the foregoing the amount of deforming operation due to difference in the environmental temperature can be eliminated by mutually canceling deforming characteristics of the first deforming characteristic member 27 and the second deforming characteristic member 29, and consequently, transmission of movement to the pointer shaft 25 is performed only by the amount of deforming movement of the first deforming characteristic member 27 in correspondence with the variation in the current passed therethrough in accordance with the changes in the detection portion, and therefore, the indication of the pointer 26 can be made accurate.

Further, the pointer shaft 25 can be rotated by the first deforming characteristic member 27 having a deforming characteristic in accordance with variation in the current passed therethrough and formed in a spiral shape, the structure of the movable portions can be simplified, efficiency in their assembling work can be improved, and the installation space of the instrument

12

can be greatly reduced.

Accordingly, the pointer shaft 25 can be rotated in accordance with the deformation characteristic of the first deforming characteristic member 27, and so, the angle of deflection of the pointer 26 can be made larger, hence, the spacing between the graduations of the scale on the dial face can be made wider, and the readability of the scale by comparison of the pointer 26 with the dial can be improved.

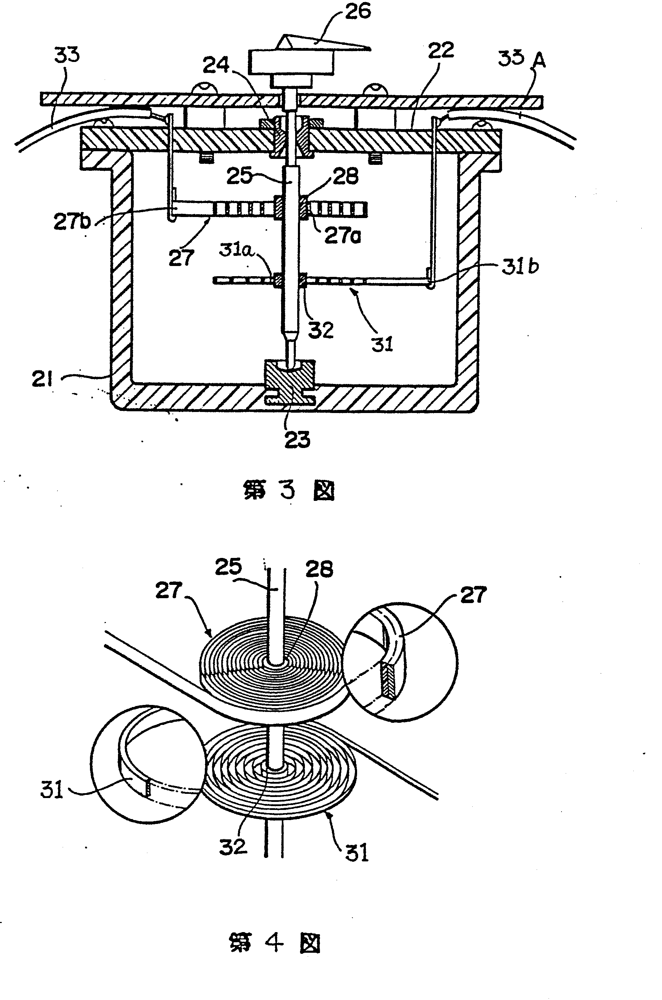

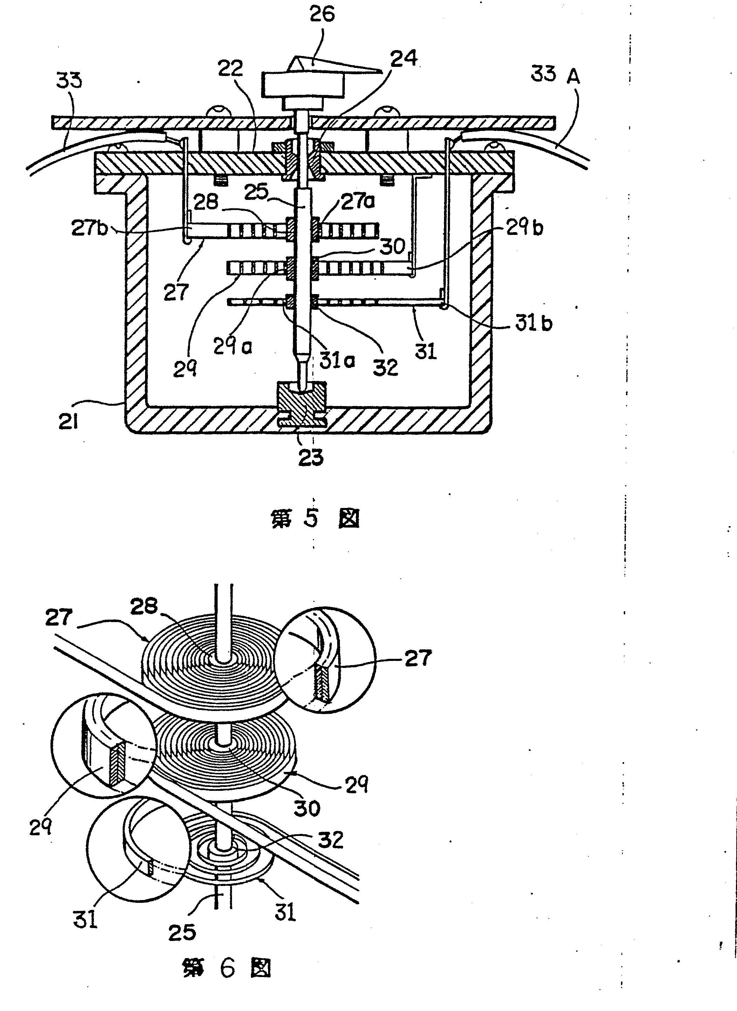

Figs. 3 and 4 show a third embodiment of the present invention, in which the body frame of the instrument is formed of an instrument frame 21 with a plate 22 mounted on the opening end thereof. A lower bearing member 23 is disposed on the instrument frame 21 and an upper bearing member 24 is disposed in the plate 22, and by both the bearing members 23 and 24 is borne a pointer shaft 25 formed of a conductive material, and a pointer 26 is fixedly pressed into the upper end of the pointer shaft 25.

Within the body frame of the instrument, there is provided a deforming characteristic member 27 made, for example, of a bimetallic material, and adapted to make deforming operation according to temperature

13

variation due to heat produced by electric current passed through resistance. The inner end 27a of the deforming characteristic member 27 is pressed into the pointer shaft 25 through a support member 28 made of a conductive material and the outer end 27b is fixed to the instrument frame 21.

The outer end 27b of the deforming characteristic member 27 is connected to a positive electrode of a detection portion of a water temperature gage, for example, for a a motor vehicle, whereby electric current is arranged to be directly passed through the deforming characteristic member 27.

And, in the present embodiment, the conductive member 31 is shaped in a spiral form, and the inner end 31a of the conductive member 31 is fixedly pressed into the pointer shaft 25 through a support member 32 with conductivity and the outer end thereof is fixed to the instrument frame 21.

The outer end 31b of the conductive member 31 is connected with the negative electrode of a detection portion of a temperature gage, for example, of a motor vehicle and the inner end 31a thereof is connected through the conductive pointer shaft 25 with the inner end 27a of the deforming characteristic member 27 for

14

electrical conduction.

Thus, according to changes in the detection portion of the indicating instrument, electric current from the positive electrode of the detection portion is input through the outer end 27b to the deforming characteristic member 27 and it is put out to the negative electrode of the detection portion through the inner end 31a of the conductive member 31 to the outer end 31b thereof. The deforming characteristic member 27 makes deforming operation according to produced heat in its resistance by the current passed therethrough, and the pointer shaft 25 is rotated to make its indication in conjunction with the deforming operation of the deforming characteristic member 27. In this manner, the deforming operation of the deforming characteristic member 27 is transmitted to the pointer shaft 25 to rotate the same so that the pointer 26 is caused to rotate to make its indication.

Even if vibration is produced in the vehicle or the like, since the electrical conductance between the respective inner ends 27a and 31a of the deforming characteristic member 27 and the conductive member 31 are secured and electrodes of the outer end 27b of the deforming characteristic member 27 and the outer end 31b

15

of the conductive member 31 are independently connected through electric cords 33 and 33A with the positive electrode and the negative electrode, respectively, of the detection portion of the temperature gage or the like, the current flow is kept in good condition. And thus, the electric current in accordance with the changes in the detection portion is certainly passed through the deforming characteristic member 27.

At this time, the heat W produced in the deforming characteristic member 27 is determined by resistance value R along the length of the deforming characteristic member 27 and the current value I passed therethrough. That is, the heat W is in the relation $W \propto Ri^2$ with the current I, and the pointer 26 is rotated through an angle corresponding to the heat W to make its indication.

As described above, even if vibration or the like is produced in a vehicle, the path of the electric current according to the changes in the detection portion is in a secured state, and therefore, the transmission of movement to the pointer shaft 25 is satisfactorily performed by the amount of deforming operation of the deforming characteristic member 27 in correspondence with the variation in the current passed

16

therethrough in accordance with the changes in the detection portion. Thus, there is no possibility of occurrence of a defective current flow and accuracy of the indication by the 26 is assured.

Further, the pointer shaft 25 can be rotated by the deforming characteristic member 27 having a deforming characteristic in accordance with variation in the current passed therethrough and formed in a spiral shape, the structure of the movable portions can be simplified, efficiency in their assembling work can be improved, and the installation space of the instrument can be greatly reduced.

Accordingly, the pointer shaft 25 can be rotated in accordance with the deformation characteristic of the deforming characteristic member 27, and so, the angle of deflection of the pointer 26 can be made larger, hence the spacing between the graduations of the scale on the dial face can be made wider, and the readability of the scale by comparison of the pointer 26 with the scale on the dial face can be improved.

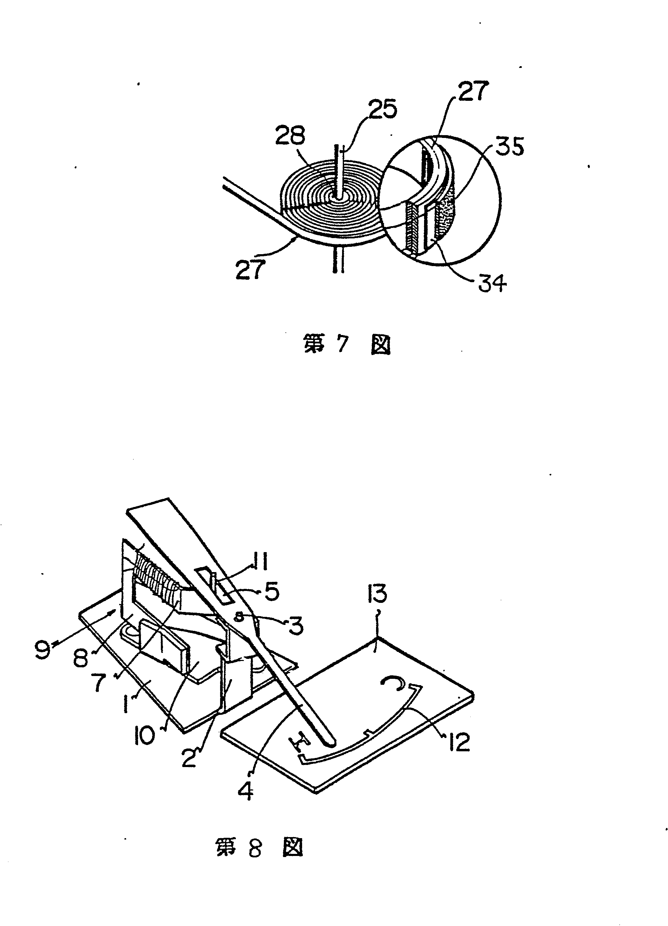

Figs. 5 and 6 show a fourth embodiment of the present invention, in which the body frame of the instrument is formed of an instrument frame 21 with a

17

plate 22 mounted on the opening end thereof. A lower bearing member 23 is disposed on the instrument frame 21 and an upper bearing member 24 is disposed in the plate 22, and by both the bearing members 23 and 24 is borne a pointer shaft 25 made of a conductive material, and a pointer 26 is fixedly pressed into the top end of the pointer shaft 25.

Within the body frame of the instrument, there is provided a first deforming characteristic member 27 made, for example, of a bimetallic material and adapted to make deforming operation according to temperature variation due to heat produced by electric current passed through resistance. The inner end 27a of the first deforming characteristic member 27 is fixedly pressed into the pointer shaft 25 through a support member 28 made of a conductive material and the outer end 27b is fixed to the instrument frame 21.

The outer end 27b of the first deforming characteristic member 27 is connected to a positive electrode of a detection portion of a temperature gage, for example, for a motor vehicle and the inner end thereof is connected to the negative electrode of the later described detection portion, whereby electric current is arranged to be directly passed through the

18

first deforming characteristic member 27.

And, in the present embodiment, a conductive member 31 shaped in a spiral form is disposed under the first deforming characteristic member 27, and the inner end 31a of the conductive member 31 is fixedly pressed into the pointer shaft 25 through a support member 32 with conductivity and the outer end thereof is fixed to the instrument frame 21.

The outer end 31b of the conductive member 31 is connected with the negative electrode of a detection portion of a temperature gage, for example, for a motor vehicle and the inner end 31a thereof is connected through the conductive pointer shaft 25 with the inner end 27a of the deforming characteristic member 27 for electrical conduction.

Within the body frame of the instrument, there is also provided a second deforming characteristic member 29 which is made, for example, of a bimetallic material, shaped in a spiral form, and adapted to make deforming operation according to temperature variation similarly to the first deforming characteristic member 27, but its spiral direction is made to be opposite to the first deforming characteristic member 27. The inner end 29a of the same is fixedly pressed into the pointer

19

shaft 25 through a support member 30 made of an insulating material and the outer end 29b is fixed to the instrument frame 21.

In the present case, as the first deforming characteristic member 27 and the second deforming characteristic member 29 are used such that will provide virtually equal characteristics as to the deforming characteristic to make deforming operation according to temperature variation.

Thus, according to changes in the detection portion of the indicating instrument, electric current from the positive electrode of the detection portion is input through the outer end 27b to the first deforming characteristic member 27 and it is put out to the negative electrode of the detection portion through the inner end 31a of the conductive member 31 to the outer end 31b thereof. The first deforming characteristic member 27 makes deforming operation according to produced heat in its resistance by the current passed therethrough, and the pointer shaft 25 is rotated to make its indication in conjunction with the deforming operation of the first deforming characteristic member 27. In this manner, the deforming operation of the first deforming characteristic member 27 is transmitted

20

to the pointer shaft 25 to rotate the same so that the pointer 26 is caused to rotate to make its indication.

Even if vibration is produced in the vehicle or the like, since the electrical conductance between the respective inner ends 27a and 31a of the first deforming characteristic member 27 and the conductive member 31 are secured and electrodes of the outer end 27b of the first deforming characteristic member 27 and the outer end 31b of the conductive member 31 are independently connected through electric cords 33 and 33A with the positive electrode and the negative electrode, respectively, of the detection portion of the temperature gage or the like, the current flow is kept in good condition. And thus, the electric current in accordance with the changes in the detection portion is certainly passed through the first deforming characteristic member 27.

And, in the present case, since the deforming characteristics of the first deforming characteristic member 27 and the second deforming characteristic member 29 to make deforming operation according to temperature variation are arranged to be virtually equal but the directions of the spirals of these members are arranged to be opposite to each other, when the amount of

21

movement of the first deforming characteristic member 27 according to the temperature difference is represented by $T_{r1}$, the amount of movement $T_{r2}$ of the second deforming characteristic member 29 according to the temperature difference is produced in the opposite direction to the amount of movement $T_{r1}$ of the first deforming characteristic member 27 and therefore becomes $T_{r2} = -T_{r1}$, and further the amount of movement $T_{r3}$ of the conductive member 31 which does not produce deforming operation according to temperature variation becomes virtually zero, and thus, the amount of relative movement at the time when temperature difference is present will be $T = T_{r1} + T_{r2} + T_{r3} = T_{r1} + (-T_{r1}) + 0 = 0$, which means that the operating torque acting on the pointer shaft 25 due to the temperature difference is nullified by the amounts of movement of both the first and second deforming characteristic members 27 and 29 canceling each other and change in the amount of indication is thereby virtually absorbed, and thus, a balanced state is secured.

In the present case, the heat W produced in the first deforming characteristic member 27 is determined by the resistance value R of the first deforming characteristic member 27 along its length and

22

the current value I passed therethrough, i.e., $W \propto RI^2$, and therefore, the pointer 26 is caused to rotate through the angle corresponding to the heat W to make its indication.

As described above, even if vibration or the like is produced in a vehicle, the path of the electric current according to the changes in the detection portion is in a secured state, and therefore, the transmission of movement to the pointer shaft 25 is satisfactorily performed by the amount of deforming operation of the first deforming characteristic member 27 in correspondence with the variation in the current passed therethrough in accordance with the changes in the detection portion. Thus, there is no possibility of occurrence of a defective current flow and accuracy of the indication by the 26 is assured.

Further, the pointer shaft 25 can be rotated by the first deforming characteristic member 27 having a deforming characteristic in accordance with variation in the current passed therethrough and formed in a spiral shape, the structure of the movable portions can be simplified, efficiency in their assembling work can be improved, and the installation space of the instrument can be greatly reduced.

Accordingly, the pointer shaft 25 can be rotated in accordance with the deformation characteristic of the first deforming characteristic member 27, and so, the angle of deflection of the pointer 26 can be made larger, hence the spacing between the graduations of the scale on the dial face can be made wider, and the readability of the scale by comparison of the pointer 26 with the scale on the dial face can be improved.

Fig. 7 shows a practical example of the present invention, in which the indicating instrumental mechanism is constructed virtually in the same way as in each of the above described embodiments and detailed description of the same is therefore omitted here.

In the present example, there is formed a resistance member 35 by such means as printing on the first deforming characteristic member 27 with an insulating layer 34 interposed therebetween, whereby it is adapted such that electric current in accordance with changes in the detection portion of the indicating instrument is passed through the resistance member 35, variation in the passed current is converted to heat in the resistance member 35, and the first deforming characteristic member 27 is caused to make deforming

24

operation in accordance with the heat.

In the described example, the resistance member 35 is provided by means of printing or the like, but it is also practicable to adhere a resistance body 35 onto the the deforming characteristic member 27.

Although the present invention has so far been described as to its embodiments as water temperature gages, level gages, or the like for vehicles, it can be applied to speed meters and tachometers for vehicles, ammeters and voltmeters for general use, and various other indicating instruments, and the input means from the detection portion to the deforming characteristic member 27 may be properly arranged from case to case.

WHAT IS CLAIMED IS:

1. An indicating instrument comprising a pointer shaft borne by bearing members within an instrument frame, a pointer fixedly attached to said pointer shaft, a deforming characteristic member making deforming operation in accordance with temperature variation due to heat produced by electric current passed through resistance and formed in a spiral shape, the inner end of said spiral deforming characteristic member being fixed to said pointer shaft and the outer end thereof being fixed to said instrument frame, wherein it is adapted such that said deforming characteristic member is caused to make deforming operation in accordance with strength of passed current and said pointer shaft is rotated in conjunction with this operation.

2. An indicating instrument according to claim 1 further comprising a second deforming characteristic member formed in the spiral shape opposite in direction to that of said deforming characteristic member making deforming operation in accordance with temperature variation due to heat

26

produced by electric current passed through resistance, the inner end of said second deforming characteristic member being fixed to said pointer shaft and the outer end thereof being fixed to said frame.

3.    An indicating instrument according to claim 1 or 2 further comprising a conductive member shaped in a spiral form of which the inner end is fixed to said pointer shaft and the outer end is fixed to said instrument frame, wherein it is adapted such that electric current can flow between the inner end of said deforming characteristic member making deforming operation in accordance with temperature variation due to heat produced by electric current passed through resistance and the inner end of said conductive member, electric cords are laid from electrode portions at their respective outer ends to outside, said deforming characteristic member is caused to make deforming operation in accordance with strength of the electric current flowing between the electrode portions, and said pointer shaft is caused to rotate in conjunction with this operation.

4.    An indicating instrument according to

27

claims 1 to 3, wherein said deforming characteristic member making deforming operation in accordance with temperature variation due to heat produced by electric current passed through resistance is provided thereon with a resistance member with an insulating layer interposed therebetween, and wherein it is adapted such that said deforming characteristic member is caused to make deforming operation in accordance with strength of electric current passed through said resistance member and said pointer shaft is caused to rotate in conjunction with this operation.

5. An indicating instrument according to claims 1 to 4, wherein said deforming characteristic member making deforming operation in accordance with temperature variation due to heat produced by electric current passed through resistance is formed of a bimetallic material.

第 1 図

第 2 図

0262264

第 3 図

第 4 図

第 5 図

第 6 図

0262264

第 7 図

第 8 図

## European Patent Office

## EUROPEAN SEARCH REPORT

| | DOCUMENTS CONSIDERED TO BE RELEVANT | | EP 86306692.4 | |
|---|---|---|---|

| Category | Citation of document with indication, where appropriate, of relevant passages | Relevant to claim | CLASSIFICATION OF THE APPLICATION (Int. Cl.4) |
|---|---|---|---|
| X | US - A - 2 875 408 (PETZINGER)<br>* Fig. 1,3,6,7 *<br>-- | 1-5 | G 01 R 5/26<br>G 01 R 19/03 |
| X | EP - A1 - 0 087 985 (GOODWIN)<br>* Fig. 1,2 *<br>-- | 1 | |
| X | FR - A - 1 536 342 (SEIGNOL)<br>* Fig. *<br>---- | 1 | |
| | | | **TECHNICAL FIELDS SEARCHED (Int. Cl.4)**<br><br>G 01 R 5/00<br>G 01 R 19/00 |

The present search report has been drawn up for all claims

| Place of search | Date of completion of the search | Examiner |
|---|---|---|
| VIENNA | 28-11-1986 | KUNZE |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO Form 1503. 03.82